# EUROPEAN PATENT APPLICATION

(11) **EP 1 865 541 A1**
(43) Date of publication of application: **12.12.2007**
(21) Application number: 06730630.8
(22) Date of filing: 30.03.2006
(51) Int. Cl.: H01L 21/027, G03F 7/20

(54) **EXPOSURE METHOD, EXPOSURE APPARATUS AND DEVICE MANUFACTURING METHOD**

(30) Priority: 31.03.2005 JP 2005103644
(71) Applicant: NIKON CORPORATION, Tokyo 100-8831 (JP)
(72) Inventor: HAGIWARA, Tsuneyuki, c/o NIKON CORPORATION, Tokyo (JP); NAGASAKA, Hiroyuki, c/o NIKON CORPORATION, Tokyo (JP)
(74) Representative: HOFFMANN EITLE
(86) International application number: PCT/JP2006/306682
(87) International publication number: WO 2006/106836

(57) **Abstract**

A liquid immersion region (LR) is formed on a measuring member (65) by use of the liquid immersion mechanism (1), and measurement is performed by receiving measurement light through liquid (LQ) which forms the liquid immersion region (LR), in order to determine an exposure condition of a substrate (P). The substrate (P) is exposed by taking into account a difference between a pressure of the liquid (LQ) in the process of measurement and that in the process of exposure and a result of the measurement thus performed.

## Description

### TECHNICAL FIELD

The present invention is related to an exposure method, an exposure apparatus and a method for fabricating a device, which are for exposing a substrate through liquid.

This application claims the benefit of Japanese Patent Application No. 2005-103644 filed on March 31, 2005, the disclosure of which is incorporated herein by reference.

### BACKGROUND ART

In a photolithography process, one of the processes for fabricating a micro device such as a semiconductor device and liquid crystal device, use is made of an exposure apparatus that project-exposes a pattern formed on a mask to a photosensitive substrate. The exposure apparatus includes a mask stage capable of holding and moving a mask and a substrate stage that is capable of being moved by supporting a substrate. The exposure apparatus is adapted to project-expose a pattern of the mask on the substrate through a projection optical system while sequentially moving the mask stage and the substrate stage. In the manufacture of micro devices, miniaturization of a pattern to be formed on the substrate is required to increase density of the devices. In order to comply with such a requirement, there is a need to further enhance a resolution power of the exposure apparatus. As one means for assuring the enhanced resolution power, there has been proposed a liquid immersion exposure apparatus which forms a liquid immersion region of a liquid on the substrate and exposes the substrate through the liquid for forming the immersion region, as disclosed in Patent Document 1 below.

Patent Document 1: PCT International Publication No. WO 99/49504.

### DISCLOSURE OF INVENTION

### PROBLEMS TO BE SOLVED BY THE INVENTION

In a liquid immersion exposure apparatus, it is conceivable to form a liquid immersion region of liquid on a given measuring member prior to liquid immersion exposure of a substrate, perform a specified measurement by receiving light through the liquid and then expose the substrate based on the measurement result. In case there is a difference between a liquid pressure in the process of measurement and a liquid pressure in the process of exposure, however, there is a possibility that the substrate cannot be reliably exposed if the exposure of the substrate is performed based on the measurement result obtained by use of the measuring member.

The present invention has been made in view of such circumstances, and it is an object of the present invention to provide an exposure method and apparatus capable of reliably exposing a substrate and a device fabricating method that makes use of the exposure method and apparatus.

### MEANS FOR SOLVING THE PROBLEM

In order to achieve these objects, the present invention employs the following configurations summarized below in conjunction with the drawings that illustrate embodiments. In this regard, reference numerals in parentheses are attached to individual elements merely for the purpose of illustration and are not intended to limit the respective elements.

In accordance with a first aspect of the present invention, there is provided an exposure method for exposing a substrate (P) by forming a liquid immersion region (LR) on the substrate (P) by use of a liquid immersion mechanism (e.g. 12) and irradiating the substrate P with exposure light (EL) through liquid (LQ) forming the liquid immersion region (LR). The exposure method includes the steps of: forming a liquid immersion region (LR) on a measuring member (65) by use of the liquid immersion mechanism (e.g. 12) and performing measurement, which is to determine an exposure condition of the substrate (P), by receiving measurement light through liquid (LQ) forming the liquid immersion region (LR); and exposing the substrate (P) by taking into account a difference between a pressure of the liquid (LQ) in the process of measurement and that in the process of exposure and a result of the measurement thus performed.

In accordance with the first aspect of the present invention, even if there is a difference between the pressure of liquid in measurement and the pressure of liquid in exposure, it is possible to reliably expose the substrate by performing the exposure of the substrate in consideration of the difference between the liquid pressure in measurement and that in exposure and the result of measurement obtained by use of the measuring member.

In accordance with a second aspect of the present invention, there is provided a device fabricating method including: using the above exposure method.

In accordance with the second aspect of the present invention, it is possible to manufacture devices by using the exposure method capable of reliably exposing the substrate.

In accordance with a third aspect of the present invention, there is provided an exposure apparatus (EX) for exposing a substrate (P) by forming a liquid immersion region (LR) on the substrate (P) by use of a liquid immersion mechanism (e.g. 12) and irradiating the substrate (P) with exposure light (EL) through liquid (LQ) forming the liquid immersion region (LR). The exposure apparatus includes a measuring device (60) that performs measurement to determine an exposure condition of the substrate (P), the measuring device (60) having a measuring member (65), the measuring device (60) adapted to receive measurement light through liquid (LQ) in the liquid immersion region (LR) formed on the measuring member (65) by use of a liquid immersion mechanism (1); and an exposure control unit (CONT) that exposes the substrate (P) while accounting for a measurement result obtained by the measuring device and a difference between a pressure of the liquid (LQ) in the process of measurement and that in the process of exposure.

In accordance with the third aspect of the present invention, even if there is a difference between the liquid pressure in measurement and the liquid pressure in exposure, it is possible to reliably expose the substrate by performing the exposure of the substrate in accordance with the result of measurement obtained by use of the measuring device and the difference between the liquid pressure in measurement and that in exposure.

In accordance with a fourth aspect of the present invention, there is provided a device fabricating method including: using the above exposure apparatus (EX).

In accordance with the fourth aspect of the present invention, it is possible to manufacture devices by using the exposure method capable of reliably exposing the substrate.

### EFFECTS OF THE INVENTION

In accordance with the present invention, it is possible to reliably expose a substrate even though there is a difference between a pressure of liquid in measurement and a pressure of liquid in exposure.

### BRIEF DESCRIPTION OF THE DRAWINGS

FIG 1 is a schematic diagram showing an exposure apparatus in accordance with a first embodiment.
FIG 2 is a view illustrating a state that a liquid immersion region is formed on a substrate.
FIG. 3 is a view illustrating a state that a liquid immersion region is formed on a measuring member.
FIG. 4 is a top plan view showing a substrate stage.
FIG. 5 is a flowchart for explaining an exposure method in accordance with a first embodiment.
FIG. 6 is a view illustrating major parts of an exposure apparatus in accordance with a second embodiment.
FIG. 7 is a flowchart for explaining an exposure method in accordance with a second embodiment.
FIG. 8 is a flowchart showing one example of a micro device fabricating process.

### DESCRIPTION OF THE REFERENCE SYMBOLS

- 1: Liquid Immersion Mechanism
- 60: Aerial Image Measuring Device,
- 65: Slit Plate,
- 80: Pressure Sensor,
- CONT: Control Unit,
- EL: Exposure Light,
- EX: Exposure Apparatus,
- K1: Light Path Space,
- LC: Imaging Characteristic Adjustment Unit,
- LQ: Liquid,
- LR: Liquid Immersion Region,
- LS1: First Optical Element,
- MRY: Storage Unit,
- P: Substrate,
- PL: Projection Optical System.

### BEST MODE FOR CARRYING OUT THE INVENTION

Hereinafter, embodiments of the present invention will be described with reference to the accompanying drawings, but the present invention will not be limited to these embodiments.

### <First Embodiment>

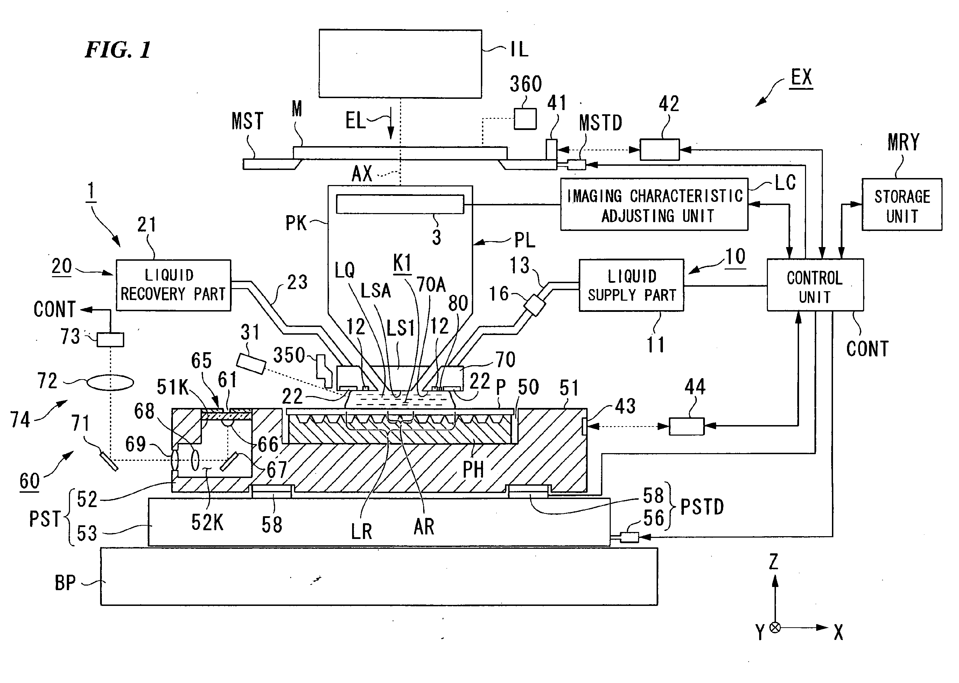

A first embodiment of an exposure apparatus EX will be described with reference to FIG 1, which is a schematic diagram showing the first embodiment of the exposure apparatus EX. In FIG 1, the exposure apparatus EX includes a mask stage MST for holding and moving a mask M, a substrate holder PH for holding a substrate P in place, a substrate stage PST capable of moving the substrate holder PH that holds the substrate P, a substrate stage PST capable of moving the substrate holder PH that holds the substrate P, an illumination optical system IL for illuminating exposure light EL on the mask M held by the mask stage MST, a projection optical system PL for projecting a pattern image of the mask M illuminated by the exposure light EL on the substrate P, and a control unit CONT for generally controlling overall operations of the exposure apparatus EX. A storage unit MRY for storing a variety of information on exposure tasks is connected to the control unit CONT. The exposure apparatus EX further includes an aerial image measuring device 60 that performs measurement for determining imaging characteristics (optical characteristics) of the projection optical system PL as an exposure condition. The aerial image measuring device 60 includes a slit plate 65 having a slit portion 61 arranged at an image plane side of the projection optical system PL, a light receiving element 73 formed of a photoelectric conversion element, and an optical system 74 for leading the light passed through the slit plate 65 to the light receiving element 73. The light receiving element 73 is adapted to receive, via the slit plate 65 and the optical system 74, the light (exposure light EL) passed through the projection optical system PL.

The exposure apparatus EX of the present embodiment is a liquid immersion exposure apparatus that makes use of a liquid immersion method to substantially shorten an exposure wavelength, thereby increasing a resolution power and substantially broadening a depth of focus. The exposure apparatus EX is provided with a liquid immersion mechanism 1 for filling liquid LQ into a light path space K1 of the exposure light EL on an image plane side of the projection optical system PL. The liquid immersion mechanism 1 is arranged in the vicinity of an image plane of the projection optical system PL. The liquid immersion mechanism 1 includes a nozzle member 70 having supply ports 12 for supply of the liquid LQ and recovery ports 22 for recovery of the liquid LQ, a liquid supply mechanism 10 for supplying the liquid LQ to the image plane side of the projection optical system PL through the supply ports 12 of the nozzle member 70, and a liquid recovery mechanism 20 for recovering the liquid LQ on the image plane side of the projection optical system PL through the recovery ports 22 of the nozzle member 70. The nozzle member 70 is arranged above the substrate P (substrate stage PST) and formed in an annular shape so as to enclose a first optical element LS 1 located nearest to the image plane of the projection optical system PL among a plurality of optical elements of the projection optical system PL.

The exposure apparatus EX adopts a local immersion method by which, while the pattern image of the mask M is being projected on the substrate P, a liquid immersion region LR of the liquid LQ larger than a projection region AR but smaller than the substrate P is locally formed on a part of the substrate P, including the projection region AR of the projection optical system PL, by use of the liquid LQ supplied from the liquid supply mechanism 10. More specifically, the exposure apparatus EX exposes the substrate P with the pattern image of the mask M, by filling the liquid LQ into the light path space K1 of the exposure light EL between the first optical element LS1 lying nearest to the image plane of the projection optical system PL and the substrate P held by the substrate holder PH and arranged at the image plane side of the projection optical system PL, and irradiating the exposure light EL passed through the mask M on the substrate P via the projection optical system PL and the liquid LQ filled into the space formed between the projection optical system PL and the substrate P. The control unit CONT is adapted to supply a prescribed quantity of liquid LQ to the substrate P with the liquid supply mechanism 10 of the liquid immersion mechanism 1 and recover a prescribed quantity of liquid LQ present on the substrate P with the liquid recovery mechanism 20, thereby filling the liquid into the light path space K1 of the exposure light EL formed between the projection optical system PL and the substrate P and locally forming the liquid immersion region LR of the liquid LQ on the substrate P.

In the present embodiment, description will be made based on an exemplary case wherein, as the exposure apparatus EX, use is made of a scan type exposure apparatus (what is called a scanning stepper) that exposes the pattern of the mask M on the substrate P while synchronously moving the mask M and the substrate P in the respective scanning directions. In the following description, the synchronous moving direction (scanning direction) of the mask M and the substrate P within a horizontal plane will be referred to as an X-axis direction, the direction orthogonal to the X-axis direction within the horizontal plane will be referred to as a Y-axis direction (non-scanning direction), and the direction perpendicular to the X-axis and Y-axis directions and coinciding with an optical axis AX of the projection optical system PL will be referred to as a Z-axis direction. Furthermore, the rotational (oblique) directions about the X-axis, Y-axis and Z-axis directions will be referred to as θX, θY and θZ directions, respectively. Moreover, the term "substrate" used herein includes a base member, such a semiconductor wafer or the like, which is coated with a photosensitive material (resist), and the term "mask" includes a reticle formed with a device pattern which is to be reduction-projected on the substrate.

The illumination optical system IL includes an exposure light source, an optical integrator for making the illuminance of light beams projected from the exposure light source uniform, a condenser lens for condensing the exposure light EL coming from the optical integrator, a relay lens array, a field diaphragm for setting an illumination region of the exposure light EL on the mask M, and so forth. The illumination optical system IL is adapted to illuminate the illumination region on the mask M with the exposure light EL of uniform illuminance distribution. As the exposure light EL emitted from the illumination optical system IL, use is made of, e.g., deep ultraviolet light (DUV light) such as emission lines (a g-line, a h-line and an i-line) emitted from a mercury lamp, KrF excimer laser light (with a wavelength of 248nm) or the like and vacuum ultraviolet light (VUV light) such as ArF excimer laser light (with a wavelength of 193nm), F₂ laser light ((with a wavelength of 157nm) or the like. The ArF excimer laser light is utilized in the present embodiment.

In the present embodiment, pure water is used as the liquid LQ. The pure water permits transmission of, e.g., deep ultraviolet light (DUV light) such as emission lines (a g-line, a h-line and an i-line) emitted from a mercury lamp, KrF excimer laser light (with a wavelength of 248nm) or the like, as well as ArF excimer laser light.

The mask stage MST is capable of holding and moving the mask M. The mask stage MST is adapted to hold the mask M by vacuum suction (or electrostatic attraction). While holding the mask M in place, the mask stage MST can be two-dimensionally moved within a plane perpendicular to the optical axis AX of the projection optical system PL, i.e., within an X-Y plane and also can be finely rotated in the θZ direction by the operation of a mask stage drive unit MSTD, including a linear motor or the like, controlled by the control unit CONT. A movable mirror 41 is provided in the mask stage MST and a laser interferometer 42 is provided in a position oppositely facing the movable mirror 41. The position in the two-dimensional direction and the rotation angle in the θZ direction of the mask M placed on the mask stage MST are measured by means of the laser interferometer 42 on a real time basis. The rotation angles in the θX and θY directions may also be measured by the laser interferometer 42. The result of measurement from the laser interferometer 42 is outputted to the control unit CONT. Based on the result of measurement from the laser interferometer 42, the control unit CONT operates the mask stage drive unit MSTD and controls the position of the mask M held in place on the mask stage MST.

The projection optical system PL is adapted to project the pattern image of the mask M on the substrate P with a predetermined projection magnification ratio β. The exposure light EL passed through the mask M reaches the substrate P via the projection optical system PL and the liquid LQ of the liquid immersion region LR. The projection optical system PL is formed of a plurality of optical elements kept in place by a lens barrel PK. In the present embodiment, the projection optical system PL is a reduction system whose projection magnification ratio β is equal to, e.g., 1/4, 1/5 or 1/8. Alternatively, the projection optical system PL may be either an equal magnification system or an enlargement system. Furthermore, the projection optical system PL may be one of a refraction system with no reflection element, a reflection system with no refraction element and a catadioptric system including a reflection element and a refraction element. Moreover, in the present embodiment, among the plurality of optical elements in the projection optical system PL, a first optical element LS 1 lying nearest to the image plane of the projection optical system PL is exposed to the outside from the lens barrel PK.

The projection optical system PL is provided with an imaging characteristic adjustment unit LC capable of adjusting imaging characteristics of the projection optical system PL, as disclosed in, e.g., Japanese Patent Application, Publication Nos. S60-78454 and H11-195602 and PCT International Publication No. WO 03/65428. The imaging characteristic adjustment unit LC includes an optical element drive unit 3 capable of moving some of the plurality of optical elements in the projection optical system PL. The optical element drive unit 3 has an ability to cause a part of the plurality of optical elements constituting the projection optical system PL to be moved in a direction of the optical axis AX (Z-axis direction) or to be inclined relative to the optical axis AX. By moving a part of the plurality of optical elements in the projection optical system PL, the imaging characteristic adjustment unit LC can adjust the imaging characteristics including various aberrations (e.g., a projection magnification ratio, a distortion and a spherical aberration) and an image plane position (focus position) of the projection optical system PL. Furthermore, as the imaging characteristic adjustment unit LC, it may be possible to include a pressure regulating mechanism for regulating the pressure of a gas present in a space formed between some of the optical elements held within the lens barrel PK. The imaging characteristic adjustment unit LC is controlled by the control unit CONT.

The substrate stage PST includes a Z-tilt stage 52 movable at the image plane side of the projection optical system PL and adapted to hold the substrate P with the substrate holder PH and an XY-stage 53 for supporting the Z-tilt stage 52. The XY-stage 53 is movably supported on a base BP. The substrate stage PST is operated by the substrate stage drive unit PSTD. The substrate stage drive unit PSTD is provided with an XY-drive mechanism 56 including, e.g., a linear motor, for moving the XY-stage 53 on the base BP in the X-axis, Y-axis and θZ directions and Z-drive mechanisms 58 including, e.g., voice coil motors, for moving the Z-tilt stage 52 in the Z-axis, θX and θY directions. The Z-drive mechanisms 58 are three in number (the one arranged on the rear side of a paper plane being not shown in the drawings) and the Z-tilt stage 52 is supported at three points on the XY-stage 53 by means of the three Z-drive mechanisms 58. The substrate stage drive unit PSTD is controlled by the control unit CONT. This enables the Z-tilt stage 52 to move the substrate P held on the substrate holder PH in the Z-axis, θX and θY directions and also enables the XY-stage 53 to move the substrate P held on the substrate holder PH in the XY and θZ directions through the Z-tilt stage 52. Thus, the surface of the substrate P held on the substrate holder PH can be moved with six degrees of freedom of movement in the X-axis, Y-axis, Z-axis, θX, θY and θZ directions. Alternatively, the Z-tilt stage and the XY-stage may be formed integrally.

The Z-tilt stage 52 (substrate stage PST) is provided with a recessed portion 50 and the substrate holder PH is arranged in the recessed portion 50. And, the upper surface 51 of the Z-tilt stage 52 around the recessed portion 50 is a flat surface having substantially the same height as (or being flush with) the surface of the substrate P held on the substrate holder PH. The upper surface 51 of the substrate stage PST is liquid repellent against the liquid LQ. Since the upper surface 51 substantially flush with the surface of the substrate P is provided around the substrate P, it is possible to continuously fill the liquid LQ into the light path space K1 on the image plane side of the projection optical system PL during the time when a peripheral edge region of the surface of the substrate P is subject to liquid immersion exposure, thereby assuring good formation of the liquid immersion region LR. So far as the light path space K1 on the image plane side of the projection optical system PL can be continuously filled with the liquid LQ, it does not matter if a difference in level exists between the surface of the substrate P held on the substrate holder PH and the upper surface 51 of the substrate stage PST.

A movable mirror 43 is provided on a side surface of the Z-tilt stage 52 and a laser interferometer 44 is provided in a position oppositely facing the movable mirror 43. The two-dimensional direction position of the substrate P placed on the substrate stage PST and the rotation angle thereof are measured by the laser interferometer 44 on a real time basis, the measurement result of which is outputted to the control unit CONT. Based on the measurement result from the laser interferometer 44, the control unit CONT operates the XY-stage 53 within a two-dimensional coordinate system defined by the laser interferometer 44 through the use of the substrate stage drive unit PSTD (the XY-drive mechanism 56), thereby determining the position in the X-axis and Y-axis directions of the substrate P supported on the substrate stage PST.

The exposure apparatus EX further includes a focus detection system (not shown) for detecting information on the surface position of the substrate P. The focus detection system includes a light projecting portion and a light receiving portion, and detects the information on the surface position of the substrate P by allowing the light projecting portion to project detection light on the surface (exposure surface) of the substrate P in an oblique direction and allowing the light receiving portion to receive the light reflected from the surface of the substrate P. The control unit CONT controls the operation of the focus detection system and detects the surface position of the substrate P relative to the image plane of the projection optical system PL based on the result of light reception in the light receiving portion.

By operating the Z-tilt stage 52 of the substrate stage PST through the use of the substrate stage drive unit PSTD (Z-drive mechanisms 58), the control unit CONT controls the position in the Z-axis direction (a focus position) and the position in the θX and θY directions of the substrate P held on the Z-tilt stage 52. In other words, the Z-tilt stage 52 is operated by a command issued from the control unit CONT based on the detection result from the focus detection system and is adapted to, by controlling the focus position (Z-position) and the inclination angles (θX and θY) of the substrate P, bring the surface (exposure surface) of the substrate P into coincidence with the image plane formed through the projection optical system PL and the liquid LQ.

In the vicinity of a tip end of the projection optical system PL, there is provided a substrate alignment system 350 that detects an alignment mark on the substrate P or a first reference mark of a reference member provided on the Z-tilt stage 52. Furthermore, the substrate alignment system 350 of the present embodiment adopts a FIA (field image alignment) method as disclosed in, e.g., Japanese Patent Application, Publication No. H04-65602 (corresponding to U.S. Patent No. 5,493,403), wherein the method includes the steps of stopping movement of the substrate stage PST, irradiating illumination light such as white light of a halogen lamp or the like on a mark, picking up an image of the mark within a prescribed field of view by use of an image pickup device and image-processing the image to thereby measure a position of the mark.

Moreover, in the vicinity of the mask stage MST, there is provided a mask alignment system 360 that detects a second reference mark of the reference member provided on the Z-tilt stage 52 through the mask M and the projection optical system PL. Furthermore, the mask alignment system 360 of the present embodiment adopts a VRA (visual reticle alignment) method as disclosed in, e.g., Japanese Patent Application, Publication No. H07-176468, wherein the method includes the steps of irradiating light on a mark, picking up an image of the mark with a CCD camera or the like and image-processing an image data of the picked-up mark to thereby detect a position of the mark.

Next, description will be made on the liquid supply mechanism 10 and the liquid recovery mechanism 20 of the liquid immersion mechanism 1. The liquid supply mechanism 10 is used to supply the liquid LQ to the image plane side of the projection optical system PL and includes a liquid supply part 11 for feeding the liquid LQ and a supply pipe 13 connected at a first end thereof to the liquid supply part 11. The supply pipe 13 is connected at a second end thereof to the nozzle member 70. Inside the nozzle member 70, there is formed an internal flow path (supply flow path) that interconnects the second end of the supply pipe 13 and the supply ports 12. The liquid supply part 11 includes a tank for receiving the liquid LQ, a compression pump, a temperature control mechanism for controlling a temperature of the liquid LQ supplied, a filter unit for removing foreign materials present in the liquid LQ, and so forth. The liquid supplying operation of the liquid supply part 11 is controlled by the control unit CONT. Furthermore, it is not necessary for the exposure apparatus EX to be equipped with the tank, the compression pump, the temperature control mechanism and the filter unit of the liquid supply mechanism 10 in their entirety. Facilities existing in a factory in which the exposure apparatus EX is installed may be utilized in place thereof.

The liquid recovery mechanism 20 serves to recover the liquid LQ present on the image plane side of the projection optical system PL and includes a liquid recovery part 21 for recovering the liquid LQ and a recovery pipe 23 connected at a first end thereof to the liquid recovery part 21. The recovery pipe 23 is connected at a second end thereof to the nozzle member 70. Inside the nozzle member 70, there is formed an internal flow path (recovery flow path) that interconnects the second end of the recovery pipe 23 and the recovery ports 22. The liquid recovery part 21 includes a vacuum system (suction device) such as a vacuum pump or the like, a gas-liquid separator for separating the liquid LQ and the gas recovered, a tank for storing the thus-recovered liquid LQ, and so forth. It is not necessary for the exposure apparatus EX to be equipped with the vacuum system, the gas-liquid separator and the tank of the liquid recovery mechanism 20 in their entirety. Facilities existing in a factory in which the exposure apparatus EX is installed may be utilized in place thereof.

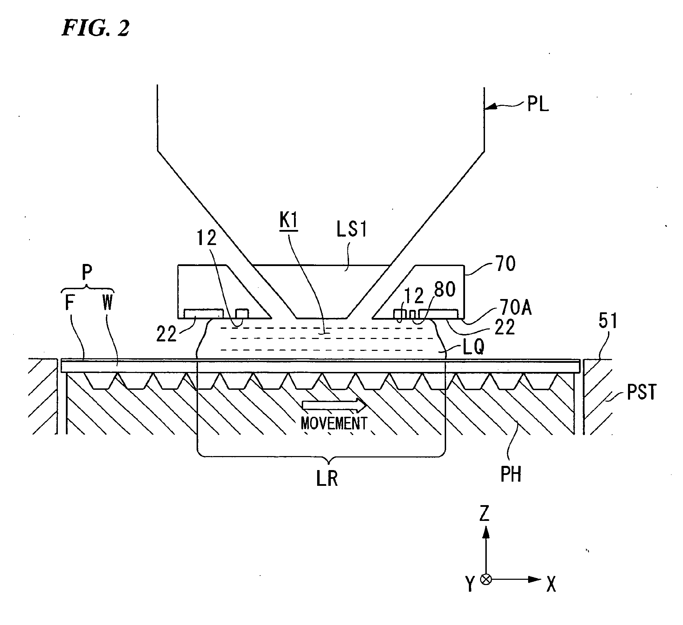

FIG. 2 is a view illustrating a state that the liquid LQ is held between the projection optical system PL and the substrate P. The supply ports 12 for supply of the liquid LQ and the recovery ports 22 for recovery of the liquid LQ are formed on a lower surface 70A of the nozzle member 70. The lower surface 70A of the nozzle member 70 is provided in such a position as to face the surface of the substrate P (the upper surface 51 of the substrate stage PST). The nozzle member 70 is an annular member adapted to enclose a side surface of the first optical element LS1. The supply ports 12 are provided in plural numbers on the lower surface 70A of the nozzle member 70 so that they can surround the first optical element LS1 of the projection optical system PL (the optical axis AX of the projection optical system PL). Moreover, the recovery ports 22 are provided on the lower surface 70A of the nozzle member 70 and are positioned more outwardly than the supply ports 12 with respect to the first optical element LS1 so that they can surround the first optical element LS 1 and the supply ports 12.

Alternatively, the supply ports 12 may be provided on an inner surface of the nozzle member 70 facing a side surface of the first optical element LS 1. Furthermore, a difference in level may exist between the lower surface of the first optical element LS1 and the lower surface of the nozzle member 70, although they are flush with each other in FIG. 1.

Moreover, a pressure sensor 80 capable of detecting a pressure of the liquid LQ in the liquid immersion region LR is provided on the nozzle member 70 in such a position as to make contact with the liquid LQ of the liquid immersion region LR. In the present embodiment, the pressure sensor 80 is provided on the lower surface 70A of the nozzle member 70.

As illustrated in FIG. 2, the substrate P is prepared by coating the surface (upper surface) of a base member W, such as a semiconductor wafer (silicon wafer) or the like, with a film F made of a photosensitive material (resist). The liquid LQ in the liquid immersion region LR makes contact with the film F of the substrate P. That is to say, the film F of the substrate P becomes a liquid contact surface that makes contact with the liquid LQ in the liquid immersion region LR. Depending on the substrate P, it may be sometimes the case that a second film is formed to cover the photosensitive material coated on the surface of the base member W. The second film is called a top coat film and is provided for the purpose of protecting the photosensitive material. The second film serves as the liquid contact surface in the event that the substrate P is provided with the second film.

At the time of forming the liquid immersion region LR of the liquid LQ, the control unit CONT operates both the liquid supply part 11 and the liquid recovery part 21. Provided from the liquid supply part 11 under the control of the control unit CONT, the liquid LQ flows through the supply pipe 13, after which the liquid LQ is fed to the image plane side of the projection optical system PL from the supply ports 12 via the supply flow path of the nozzle member 70. Furthermore, if the liquid recovery part 21 is operated under the control of the control unit CONT, the liquid LQ existing on the image plane side of the projection optical system PL is introduced into the recovery flow path of the nozzle member 70 through the recovery ports 22 and is then collected in the liquid recovery part 21 through the recovery pipe 23.

At the time when the substrate P is subject to liquid immersion exposure, the control unit CONT fills the liquid LQ into the light path space K1 of the exposure light EL formed between the projection optical system PL and the substrate P held on the substrate holder PH by use of the liquid immersion mechanism 1 and irradiates the exposure light EL on the substrate P through the projection optical system PL and the liquid LQ while moving the substrate P relative to the projection optical system PL (light path space K1).

Next, description will be made on the aerial image measuring device 60. Referring to FIG. 1, the aerial image measuring device 60 is used in measuring the imaging characteristics (optical characteristics) of the projection optical system PL and includes a slit plate 65 provided on the Z-tilt stage 52, a first optical element 66 arranged in a position near to the slit plate 65 within an internal space 52K of the Z-tilt stage 52, a mirror 67 for changing a light path of the light passed through the first optical element 66, a second optical element 68 on which the light coming from the mirror 67 impinges, a third optical element 69 for sending the light passed through the second optical element 68 to the outside of the Z-tilt stage 52, a mirror 71 provided outside the Z-tilt stage 52 for changing the light path of the light coming from the third optical element 69, a fourth optical element 72 for receiving the light from the mirror 71, and a light receiving element (photosensor) 73 including a photoelectric conversion element for receiving the light passed through the fourth optical element 72. An optical system 74 for leading the light passed through the slit plate 65 to the light receiving element 73 includes the first optical element 66, the mirror 67, the second optical element 68, the third optical element 69, the mirror 71 and the fourth optical element 72. As the light receiving element 73, use is made of a photoelectric conversion element, e.g., a photomultiplier tube (PMT), capable of detecting light of low intensity with increased accuracy. The light receiving element 73 is adapted to receive, via the slit plate 65 and the optical system 74, the light (exposure light EL) passed through the projection optical system PL. Photoelectrically converted signals issued from the light receiving element 73 are led to the control unit CONT through a signal processing unit.

Furthermore, the upper surface (external surface) of the slit plate 65 is provided to be substantially in the same height as (flush with) the surface of the substrate P held on the substrate stage PST and the upper surface 51 of the substrate stage PST (Z-tilt stage 52).

Moreover, as for the detailed construction and measuring operation of the aerial image measuring device 60, use may be made of the one as disclosed in, e.g., Japanese Patent Application, Publication Nos. 2002-14005 and 2002-198303.

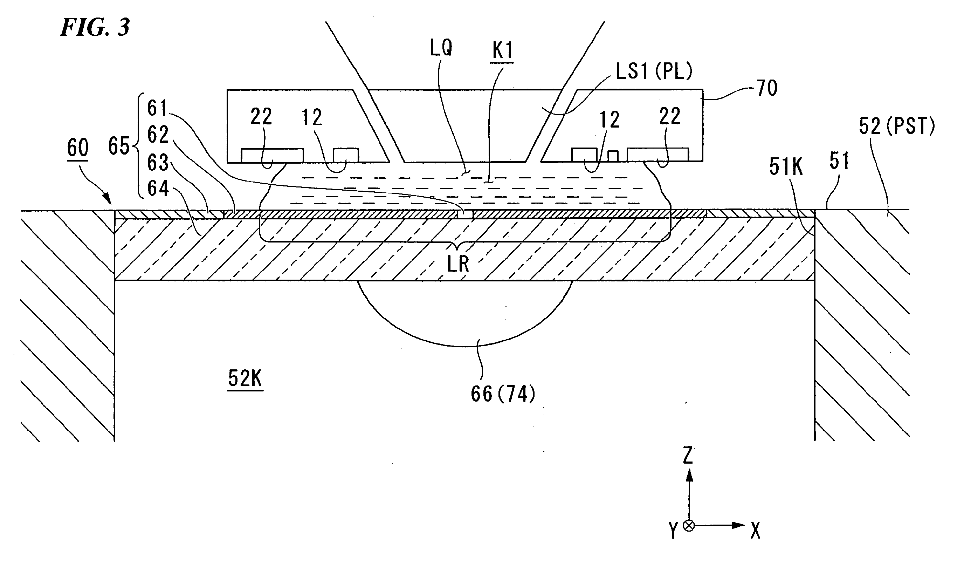

FIG. 3 is a view illustrating a state that the liquid LQ is held between the projection optical system PL and the slit plate 65. The slit plate 65 includes a glass plate member 64 having a rectangular shape when seen from the top, a light shielding film 62 made of chromium or the like and provided on an upper center surface portion of the glass plate member 64, a reflection film 63 made of aluminum or the like and provided around the light shielding film 62, i.e., on an upper surface portion of the glass plate member 64 other than the light shielding film 62, and a slit portion 61, i.e., an aperture pattern (light transmitting portion), formed in a part of the light shielding film 62. The glass plate member 64 is transparent and bared in the slit portion 61, which means that the light can pass through the slit portion 61. The slit portion 61 is a recessed portion formed in a part of the light shielding film 62. As a material for producing the glass plate member 64, use is made of silica glass, calcium fluorite or the like, which exhibits a good transmission property with respect to ArF excimer laser light or KrF excimer laser light. The slip portion 61 can be formed by, e.g., etching the light shielding film 62. Additionally, the recessed portion forming the slit portion 61 and the light shielding film 62 may be coated with a light transmitting material (e.g., SiO₂ and so forth).

As illustrated in FIG. 3, the Z-tilt stage 52 is provided with an opening portion 51K in a part of the upper surface 51 thereof, and the slit plate 65 is inserted into the opening portion 51K. Furthermore, an internal space 52K adjacent the opening portion 51 K is formed inside the Z-tilt stage 52, and a part of the optical system 74 of the aerial image measuring device 60 is arranged in the internal space 52K. The first optical element 66 as a part of the optical system 74 is arranged within the internal space 52K of the Z-tilt stage 52 and integrally formed with the glass plate member 64 below the slit portion 61. Therefore, even in case the number of aperture NA of the projection optical system PL for liquid immersion use is equal to or greater than 1, the light coming from the projection optical system PL is allowed to impinge on the first optical element 66 via the liquid LQ, the slit portion 61 and the glass plate member 64 but without passing through a gas region. The number of aperture NA of the projection optical system PL is increased if the liquid LQ is filled in the space formed between the projection optical system PL and the slit plate 65. For this reason, unless the number of aperture NA of the first optical element 66 of the aerial image measuring device 60 is increased in accordance with the number of aperture NA of the projection optical system PL, there is a possibility that it becomes impossible for the first optical element 66 to receive the light passed through the projection optical system PL in a good manner (in its entirety). In the present embodiment, the first optical element 66 is arranged to ensure that the light passed through the slit portion 61 of the slit plate 65 does not travel through a gas-filled space. Thus, the first optical element 66 is capable of reliably receive the light coming from the projection optical system PL through the liquid.

In the present embodiment, the slit portion 61 formed in a part of the light shielding film 62 is of a line pattern having a rectangular shape whose long side extends in the Y-axis direction, and has predetermined width and length. The slit portion is not limited to the line pattern but may be suitably changed in number, shape, size, and the like in accordance with the contents measured by the aerial image measuring device 60.

In this regard, the upper surface of the slit plate 65 of the present embodiment includes an upper surface of the light shielding film 62 and an upper surface of the reflection film 63. Therefore, the upper surface of the light shielding film 62, the upper surface of the reflection film 63 and the upper surface 51 of the substrate stage PST are substantially flush with one another, and the slit portion 61 of the aerial image measuring device 60 is formed within a prescribed plane including the upper surface 51 of the substrate stage PST and the upper surface of the slit plate 65.

Furthermore, the liquid LQ in the liquid immersion region LR makes contact with the light shielding film 62 and the reflection film 63 of the slit plate 65 and so forth. In other words, the light shielding film 62 of the slit plate 65 and the like serve as a liquid contact surface that makes contact with the liquid LQ of the liquid immersion region LR.

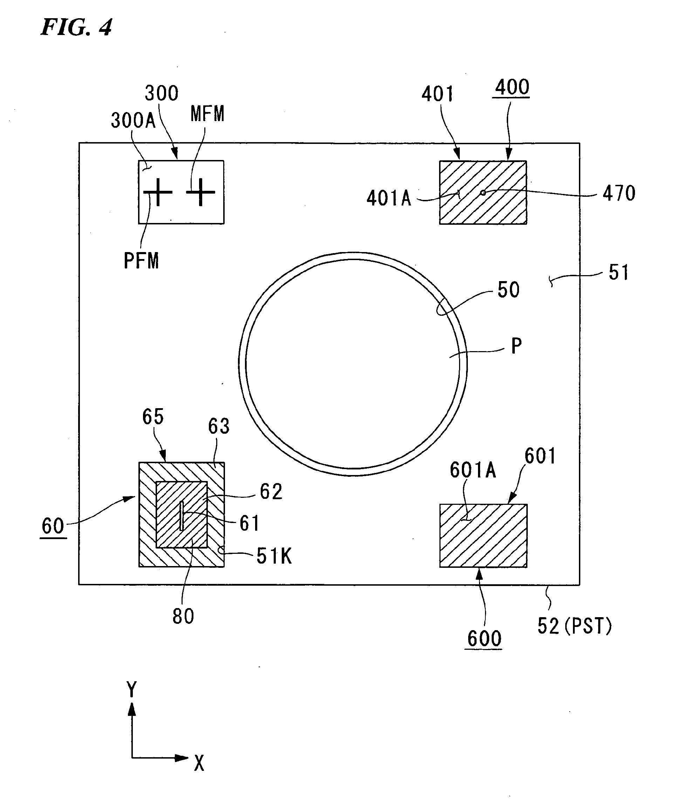

FIG. 4 is a top plan view illustrating the substrate stage PST (Z-tilt stage 52) that holds the substrate P in place. In a given position near the substrate P on the substrate stage PST (Z-tilt stage 52), there is provided the slit plate 65 with the slit portion 61 of the aerial image measuring device 60 as set forth above.

Furthermore, a reference member 300 is arranged in a given position near the substrate P on the substrate stage PST. A first reference mark PFM detected by the substrate alignment system 350 and a second reference mark MFM detected by the mask alignment system 360 are provided in the reference member 300 in a prescribed positional relationship with each other. The reference member 300 has a generally planar upper surface 300A provided substantially in the same height as (flush with) the surface of the substrate P held on the substrate stage PST and the upper surface 51 of the substrate stage PST (Z-tilt stage 52). The upper surface 300A of the reference member 300 may also serve as a reference surface of the focus detection system.

Furthermore, in a given position near the substrate P on the substrate stage PST, there is arranged a top plate 401 as a part of an illuminance unevenness sensor 400 as disclosed in, e.g., Japanese Patent Application, Publication No. 57-117238 (corresponding to U.S. Patent No. 4,465,368). The top plate 401 has a generally planar upper surface 401A provided substantially in the same height as (flush with) the surface of the substrate P held on the substrate stage PST and the upper surface 51 of the substrate stage PST. On the upper surface 401A of the top plate 401, there is provided a pinhole portion 470 that permits transmission of the light therethrough. The upper surface 40 1 A around the pinhole portion 470 is covered with a light shielding film made of chromium or the like.

Furthermore, in a given position near the substrate P on the substrate stage PST, there is arranged a top plate 601 of an irradiation amount sensor (illuminance sensor) 600 as disclosed in, e.g., Japanese Patent Application, Publication No. H11-16816. The top plate 601 has a generally planar upper surface 601 A provided substantially in the same height as (flush with) the surface of the substrate P held on the substrate stage PST and the upper surface 51 of the substrate stage PST.

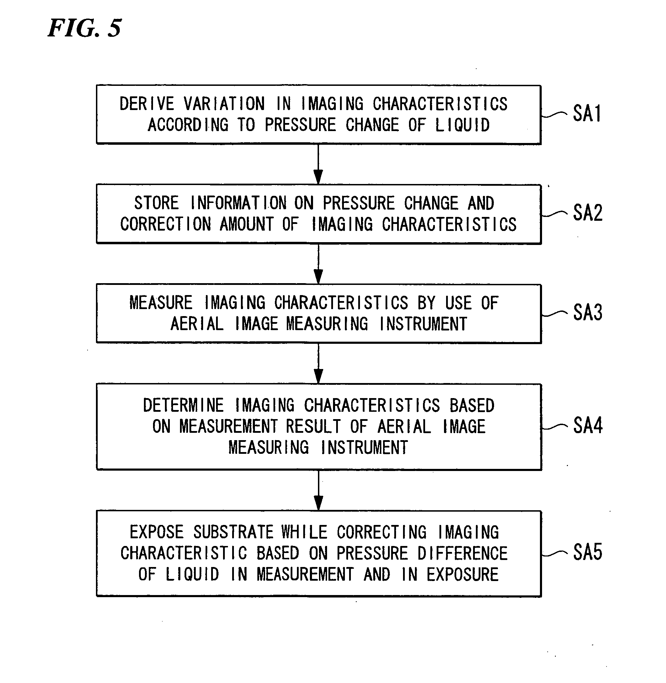

Next, a method of exposing the substrate P with the exposure apparatus EX of the construction set forth above will be described with reference to the flowchart of FIG. 5.

Prior to exposing the substrate P, the control unit CONT performs test exposure with respect to a test substrate Pt for test exposure use as distinguished from the substrate P for the manufacture of devices, and derives the correlation between a pressure of the liquid LQ forming the liquid immersion region LR and a correction value for the imaging characteristics of the projection optical system PL required to optimize the imaging characteristics associated with the projection optical system PL and the liquid LQ (Step SA1).

More specifically, the control unit CONT forms the liquid immersion region LR on the test substrate Pt by filling the liquid LQ into the light path space K1 formed between the projection optical system PL and the test substrate Pt held on the substrate holder PH, and performs the test exposure for the test substrate Pt while the pressure of the liquid LQ in the liquid immersion region LR is being changed. The test substrate Pt is substantially the same one as the substrate P for the manufacture of devices, the base member W of which is coated with the film F made of a photosensitive material or a top coat film. During the process of exposing the test substrate Pt, a test mask having a test pattern is held on the mask stage MST. While the test substrate Pt is being subject to exposure, the pressure of the liquid LQ in the liquid immersion region LR is detected by the pressure sensor 80, the detection result of which is outputted to the control unit CONT.

The control unit CONT exposes a plurality of test substrate Pt one after another in a plurality of pressure conditions of the liquid LQ. The test substrates Pt that have been test-exposed under the plurality of pressure conditions of the liquid LQ are subject to development treatment, and the shape of patterns formed on the test substrates Pt are measured by a specified pattern shape measuring device. In accordance with the pressure of the liquid LQ (the detection result of the pressure sensor 80) at the time of performing the test exposure and the shape of patterns formed on the test substrate Pt exposed under that pressure (the measurement result of the pattern shape measuring device), the control unit CONT is capable of deriving the correlation between a change in the pressure of the liquid LQ forming the liquid immersion region LR and a change of the image formed through the projection optical system PL and the liquid LQ. Based on the result thus obtained, the control unit CONT can derive the correlation (a relational expression, a table data, a map data, etc.) between the change in the pressure of the liquid LQ forming the liquid immersion region LR and the correction value of the imaging characteristics of the projection optical system PL required to optimize the imaging characteristics attained through the projection optical system PL and the liquid LQ.

In this respect, description will be made on a method for changing the pressure of the liquid LQ at the time of exposing the test substrate Pt.

The pressure of the liquid LQ forming the liquid immersion region LR is changed depending on a contact angle between the liquid LQ and the liquid contact surface of an object arranged in a facing relationship with the first optical element 66 and brought into contact with the liquid LQ. As an example, if the contact angle between the liquid LQ and the liquid contact surface of the object is large, in other words, if the liquid contact surface of the object exhibits liquid repellency, the pressure of the liquid LQ in the liquid immersion region LR making contact with the object is apt to grow high. On the other hand, if the contact angle between the liquid LQ and the liquid contact surface of the object is small, in other words, if the liquid contact surface of the object is liquid-attractive, the pressure of the liquid LQ in the liquid immersion region LR making contact with the object is apt to become low. Therefore, in order to perform the test exposure while the pressure of the liquid LQ in the liquid immersion region LR being changed, a plurality of test substrates Pt having films (liquid contact surfaces) F of different contact angles with the liquid LQ may be subject to liquid immersion exposure. In this case, the films forming the liquid contact surfaces of the test substrates Pt may be either a photosensitive agent (resist) or a protection film (top coat film) used in protecting the photosensitive agent or the like.

Furthermore, the pressure of the liquid LQ forming the liquid immersion region LR is also changed depending on a moving speed of the object kept in contact with the liquid LQ. Therefore, in order to perform the test exposure while the pressure of the liquid LQ in the liquid immersion region LR is being changed, the liquid immersion exposure may be performed by changing the moving speed (scanning speed) of the test substrate Pt relative to the liquid LQ filled in the light path space K1.

Furthermore, the pressure of the liquid LQ forming the liquid immersion region LR is also changed by adjustment of at least one of liquid supply and recovery amounts. Therefore, in order to perform the test exposure while the pressure of the liquid LQ in the liquid immersion region LR is being changed, the liquid immersion exposure may be performed by changing at least one of the liquid supply amounts of the liquid supply mechanism 10 and the liquid recovery amount of the liquid recovery mechanism 20. Although a plurality of test substrates Pt are exposed under different pressure conditions of the liquid LQ in the present embodiment, it may be possible to expose a plurality of different regions on a single test substrate Pt by changing the pressure conditions of the liquid LQ.

In the manner as noted above, the control unit CONT derives the correlation between a change in the pressure of the liquid LQ and a correction amount for the imaging characteristics of the projection optical system PL required to optimize the imaging characteristics of a pattern image formed through the projection optical system PL and the liquid LQ, and stores the thus-derived correlation in the storage unit MRY (step SA2).

Subsequently, the control unit CONT performs measurement of the pattern image formed through the projection optical system PL and the liquid LQ to find one of the exposure conditions by use of the aerial image measuring device 60 (step SA3). During the process of performing the measurement by use of the aerial image measuring device 60, a measurement mask formed with a pattern for measurement of an aerial image is held on the mask stage MST. Alternatively, a measurement pattern formed on a part of the mask stage MST may be used in place of the measurement mask. Moreover, the substrate P for the manufacture of devices is held (loaded) in advance on the substrate stage PST (substrate holder PH).

During the course of measurement by use of the aerial image measuring device 60, the control unit CONT fills the liquid LQ into the light path space K1 formed between the projection optical system PL (first optical element LS1) and the slit plate 65 by use of the liquid immersion mechanism 1, thus forming the liquid immersion region LR of the liquid LQ on the slit plate 65. That is to say, at the time of measurement by use of the aerial image measuring device 60, the liquid LQ is held between the projection optical system PL (first optical element LS1) and the slit plate 65. The liquid immersion mechanism 1 is adapted to form the liquid immersion region LR on the slit plate 65 so that the slit portion 61 can be covered with the liquid LQ.

In a state that the light path space K1 formed between the first optical element LS 1 and the slit plate 65 is filled with the liquid LQ, the control unit CONT allows the illumination optical system IL to project the exposure light EL which in turn is irradiated on the slit plate 65 after passing through the measurement mask, the projection optical system PL and the liquid LQ in the liquid immersion region LR. The light passed through the slit portion 61 of the slit plate 65 is impinged on the first optical element 66 of the optical system 74.

The light condensed in the first optical element 66 is led to the light receiving element 73 by means of the optical system 74 including the first optical element 66. In this manner, the light receiving element 73 of the aerial image measuring device 60 receives the exposure light EL through the projection optical system PL, the liquid LQ forming the liquid immersion region LR and the slit portion 61. The light receiving element 73 outputs photoelectrically converted signals (light intensity signals) corresponding to the amount of light received to the control unit CONT via the signal processing unit. The control unit CONT executes a specified operational processing based on the light reception result of the light receiving element 73 and finds the imaging characteristics associated with the projection optical system PL and the liquid LQ.

Furthermore, the control unit CONT makes use of the pressure sensor 80 to detect the pressure of the liquid LQ in the liquid immersion region LR at the time when measurement is conducted by use of the aerial image measuring device 60. The control unit CONT stores in the storage unit MRY, the information on the pressure of the liquid LQ in the liquid immersion region LR at the time of measurement by use of the aerial image measuring device 60 (the detection result of the pressure sensor 80).

Then, the control unit CONT-displaces the substrate stage PST in the XY directions and allows the liquid immersion region LR of the liquid LQ formed on the image plane side of the projection optical system PL to move from the slit plate 65 to the top plate 401 of the illuminance unevenness sensor 400. Subsequently, the control unit CONT irradiates the exposure light EL on the top plate 401 through the projection optical system PL and the liquid LQ in the liquid immersion region LR, and finds an illuminance unevenness of the exposure light EL in the projection region AR by use of the illuminance unevenness sensor 400. Moreover, after the illuminance unevenness sensor 400 has completed its measurement task, the control unit CONT displaces the substrate stage PST in the XY directions and allows the liquid immersion region LR of the liquid LQ formed on the image plane side of the projection optical system PL to move onto the top plate 601 of the irradiation amount sensor 600. Then, the control unit CONT irradiates the exposure light EL on the top plate 601 through the projection optical system PL and the liquid LQ in the liquid immersion region LR, and finds an illuminance of the exposure light EL by use of the irradiation amount sensor 600. Furthermore, after the irradiation amount sensor 600 has completed its measurement task, the control unit CONT displaces the substrate stage PST in the XY directions and allows the liquid immersion region LR of the liquid LQ formed on the image plane side of the projection optical system PL to move onto the reference member 300. And, the control unit CONT makes use of the mask alignment system 360 to measure the reference mark MFM through the projection optical system PL and the liquid LQ in the liquid immersion region LR. In addition, the control unit CONT makes use of the substrate alignment system 350 to measure the reference mark PFM. Thus, the positional relationship (base line value) between a detection reference position of the substrate alignment system 350 and a projection position of the pattern image is found prior to exposing the substrate P.

In the foregoing description, the measurement tasks are sequentially performed by moving the liquid immersion region AR2 of the liquid LQ onto the slit plate 65 of the aerial image measuring device 60, the top plate 401 of the illuminance unevenness sensor 400, the top plate 601 of the irradiation amount sensor 600 and the reference member 300 in the named order. However, the order of measurement is not limited to the one described above but may be arbitrarily set. Furthermore, the measurement tasks may be performed by some of the aerial image measuring device 60, the illuminance unevenness sensor 400, the irradiation amount sensor 600 and the reference member 300. Some measurement tasks may be conducted with no formation of the liquid immersion region LR of the liquid LQ.

Based on the measurement using the aerial image measuring device 60 and the measurement using the illuminance unevenness sensor 400 or the irradiation amount sensor 600, the control unit CONT determines the imaging characteristics of the pattern image formed through the projection optical system PL and the liquid LQ, which is one of the exposure conditions at the time of liquid immersion exposure of the substrate P (step SA4). More specifically, based on the measurement result from the aerial image measuring device 60, the control unit CONT determines an operation value (correction value) of the imaging characteristic adjusting unit LC required to adjust the imaging characteristics of the pattern image formed through the projection optical system PL and the liquid LQ.

Next, in order to expose the substrate P for the manufacture of devices, the control unit CONT displaces the substrate stage PST in the XY directions and brings the liquid immersion region LR of the liquid LQ formed on the image plane side of the projection optical system PL onto the substrate P. By doing so, the liquid LQ is held between the projection optical system PL (first optical element LS1) and the substrate P in the process of exposing the substrate P. It is a matter of course that, at the time of exposing the substrate P for the manufacture of devices, the mask M for forming the devices is held on the mask stage MST.

In a state that the liquid immersion region LR of the liquid LQ is moved onto the substrate P and hence the light path space K1 formed between the projection optical system PL and the substrate P is filled with the liquid LQ, the control unit CONT allows the illumination optical system IL to emit the exposure light and irradiate the mask M with the exposure light EL, thus ensuring that the pattern image of the mask M is projected on the substrate P through the projection optical system PL and the liquid LQ in the liquid immersion region LR formed on the substrate P. Since the exposure apparatus EX of the present embodiment is what is called a scanning stepper as described above, the control unit CONT exposes the substrate P while the substrate P being moved relative to the liquid LQ filled in the light path space K1.

In this connection, as described above, the pressure of the liquid LQ forming the liquid immersion region LR varies with the contact angle between the liquid LQ and the object making contact with the liquid LQ. Thus, if the contact angle between the surface (liquid contact surface) of the slit plate 65 and the liquid LQ differs from the contact angle between the surface (liquid contact surface) of the substrate P and the liquid LQ, it may be sometimes the case that the pressure of the liquid LQ in the liquid immersion region LR formed on the slit plate 65 becomes different from the pressure of the liquid LQ in the liquid immersion region LR formed on the substrate P. In other words, there is a possibility that the pressure of the liquid LQ in the liquid immersion region LR in the process of measurement conducted by use of the aerial image measuring device 60 differs from that in the process of exposure of the substrate P. In a nutshell, due to the difference in the contact angle that the liquid LQ makes with the surface of the slit plate 65 and the surface of the substrate P, a pressure difference may possibly occur between the liquid LQ in the process of measurement conducted by use of the aerial image measuring device 60 and the liquid LQ in the process of exposure of the substrate P.

The first optical element LS1 through which the exposure light EL passes may possibly be displace or deformed by the pressure of the liquid LQ, and the displacement amount or deformation amount of the first optical element LS1 is likely to vary with the pressure value of the liquid LQ. The displacement or deformation of the first optical element LS1 causes a change in the imaging characteristics associated with the projection optical system PL and the liquid LQ. For this reason, even though the imaging characteristics of the projection optical system PL are adjusted in step SA4 by use of the imaging characteristic adjusting unit LC based on the measurement result from the aerial image measuring device 60, there is a possibility that, in the process of exposure of the substrate P, the pattern image is not formed in an optimized imaging state through the projection optical system PL and the liquid LQ.

In view of this, the control unit CONT detects the pressure of the liquid LQ in the liquid immersion region LR in the process of exposure of the substrate P and derives a difference between the pressure of the liquid LQ in measurement and that in exposure from the pressure detection result thus obtained. Inasmuch as the pressure of the liquid LQ in the process of measurement conducted by use of the aerial image measuring device 60 has already been measured by the pressure sensor 80 in step SA3, the control unit CONT can find the difference between the pressure of the liquid LQ in the process of measurement conducted by use of the aerial image measuring device 60 and that in the process of exposure of the substrate P, based on the pressure of the liquid LQ in the liquid immersion region LR in the process of measurement conducted by use of the aerial image measuring device 60, which was detected in step SA3, and the pressure of the liquid LQ in the liquid immersion region LR in the process of exposure of the substrate P.

Furthermore, since the correction value for the imaging characteristics of the projection optical system PL in accordance with the pressure change of the liquid LQ forming the liquid immersion region LR has been already stored in step SA2, the control unit CONT can project the pattern image on the substrate P in an optimized imaging state by controlling the imaging characteristic adjusting unit LC based on the measurement result obtained by the aerial image measuring device 60 and the difference between the pressure of the liquid LQ in measurement and that in exposure. That is to say, based on the difference between the pressure of the liquid LQ in measurement and that in exposure, the control unit CONT corrects the imaging characteristics of the projection optical system PL determined in step SA4 by the measurement result from the aerial image measuring device 60 (in other words, corrects the correction value of the imaging characteristic adjusting unit LC required to obtain that imaging characteristics), and then exposes the substrate P under the imaging characteristics thus corrected (Step SA5).

Furthermore, the pressure of the liquid LQ forming the liquid immersion region LR is also changed depending on a moving speed of the object that makes contact with the liquid LQ. Therefore, if the moving state of the slit plate 65 relative to the liquid LQ of the light path space K1 in the process of measurement conducted by use of the aerial image measuring device 60 differs from the moving state of the substrate P relative to the liquid LQ of the light path space K1 in the process of exposure of the substrate P, there is a possibility that the pressure of the liquid LQ in the liquid immersion region LR formed on the slit plate 65 becomes different from the pressure of the liquid LQ in the liquid immersion region LR formed on the substrate P.

In this case, the control unit CONT can also detect the pressure of the liquid LQ in the liquid immersion region LR in the process of exposure of the substrate P by use of the pressure sensor 80 and can find the difference between the pressure of the liquid LQ in measurement and that in exposure from the pressure detection result. Then, the control unit CONT can project the pattern image on the substrate P in an optimized imaging state by controlling the imaging characteristic adjusting unit LC based on the measurement result obtained by the aerial image measuring device 60 and the difference of the pressure of the liquid LQ in measurement and that in exposure.

As described above, even if there is a difference between the pressure of the liquid LQ in the process of measurement conducted by use of the aerial image measuring device 60 and the pressure of the liquid LQ in the process of exposure of the substrate P, it is possible to reliably expose the substrate P by performing the exposure in consideration of the difference between the pressure of the liquid LQ in measurement and that in exposure and the measurement result obtained by use of the slit plate 65. It is highly likely that the kind (physical properties) of the film F formed on the substrate P is changed depending on a variety of process conditions at the time of fabricating devices and the contact angle between the substrate P and the liquid LQ is likely to change accordingly. There is also a high possibility that the moving state (the moving speed, etc.) of the substrate P in the process of exposure thereof is differently changed depending on the various process conditions. In the meantime, the aerial image measuring device 60 (slit plate 65) is mounted to the exposure apparatus EX, making it difficult to change the contact angle between the slit plate 65 and the liquid LQ depending on the substrate P. In the present embodiment, attention is paid to the difference between the pressure of the liquid LQ in measurement and that in exposure, and the imaging characteristics (exposure conditions) determined by the measurement result from the aerial image measuring device 60 is corrected based on the difference between the pressure of the liquid LQ in measurement and that in exposure, thereby making it possible to obtain an optimal imaging characteristics in accordance with the pressure of the liquid LQ in exposure.

Furthermore, since the pressure of the liquid LQ in the process of measurement conducted by the aerial image measuring device 60 undergoes little change (exhibits high reproducibility), it may be possible in the foregoing embodiment that, by using the pressure of the liquid LQ in the process of measurement conducted by the aerial image measuring device 60 as a reference pressure, the correlation between the pressure change relative to the reference pressure and the variation in the imaging characteristics is found in step SA1 and the correlation between the pressure change relative to the reference pressure and the correction value of the imaging characteristics is stored in the storage unit MRY in step SA2.

Moreover, in the present embodiment, the pressure of the liquid LQ is detected by use of the pressure sensor 80 and the substrate P is exposed while, based on the detection result from the pressure sensor 80, adjusting the imaging characteristics of the projection optical system PL by use of the imaging characteristic adjusting unit LC so as to reduce an exposure error attributable to the difference between the pressure of the liquid LQ in measurement and that in exposure. As an alternative example, prior to irradiating the exposure light EL on the substrate P, the pressure of the liquid LQ may be detected by use of the pressure sensor 80 while the substrate P (or a measurement substrate whose surface is coated with the same film as the substrate P) is being moved relative to the liquid LQ filled in the light path space K1, and the correction value for correction of the imaging characteristics determined in step SA4 may be derived based on the detection result. In this case, at the time when the substrate P is exposed by irradiating the exposure light EL on the substrate P, it is possible to irradiate the exposure light EL on the substrate P by adjusting the imaging characteristics of the projection optical system PL by use of the imaging characteristic adjusting unit LC but without having to use the pressure sensor 80.

Furthermore, in case the pressure of the liquid LQ is known in advance, the control unit CONT may derive the operation value (correction value) of the imaging characteristic adjusting unit LC so as to assure an optimized imaging state of the pattern image formed through the projection optical system PL and the liquid LQ, based on the measurement result from the aerial image measuring device 60, the known information on the pressure of the liquid LQ in measurement and the known information on the pressure of the liquid LQ in exposure but without having to use the pressure sensor 80.

More specifically, if the information on the contact angles that the slit plate 65 and the substrate P liquid LQ make with the liquid LQ is already known, the information on the pressure of the liquid LQ in accordance with the contact angle information can be found by an experiment and/or a simulation. Therefore, the substrate P can be exposed with a desired pattern image by adjusting the imaging characteristics of the projection optical system PL by use of the imaging characteristic adjusting unit LC in accordance with the contact angles of the surface of the slit plate 65 and the surface of the substrate P with the liquid LQ.

Similarly, if the movement information (speed information, etc.) of the slit plate 65 and the substrate P is already known, it is possible to find the information on the pressure of the liquid LQ in accordance with the movement information. Therefore, the substrate P can be exposed with a desired pattern image by adjusting the imaging characteristics of the projection optical system PL by use of the imaging characteristic adjusting unit LC in accordance with the moving state of the slit plate 65 in measurement and the moving state of the substrate P in exposure.

Furthermore, in the present embodiment, the imaging characteristics determined by the measurement result from the aerial image measuring device 60 are corrected based on the difference between the pressure of the liquid LQ in measurement and that in exposure, and the substrate P is exposed under the conditions of the thus-corrected imaging characteristics. Alternatively, the measurement result from the aerial image measuring device 60 may be corrected in accordance with the difference between the pressure of the liquid in measurement and that in exposure, and the substrate P may be exposed under the exposure conditions (imaging characteristics) determined by the thus-corrected measurement result.

### <Second Embodiment>

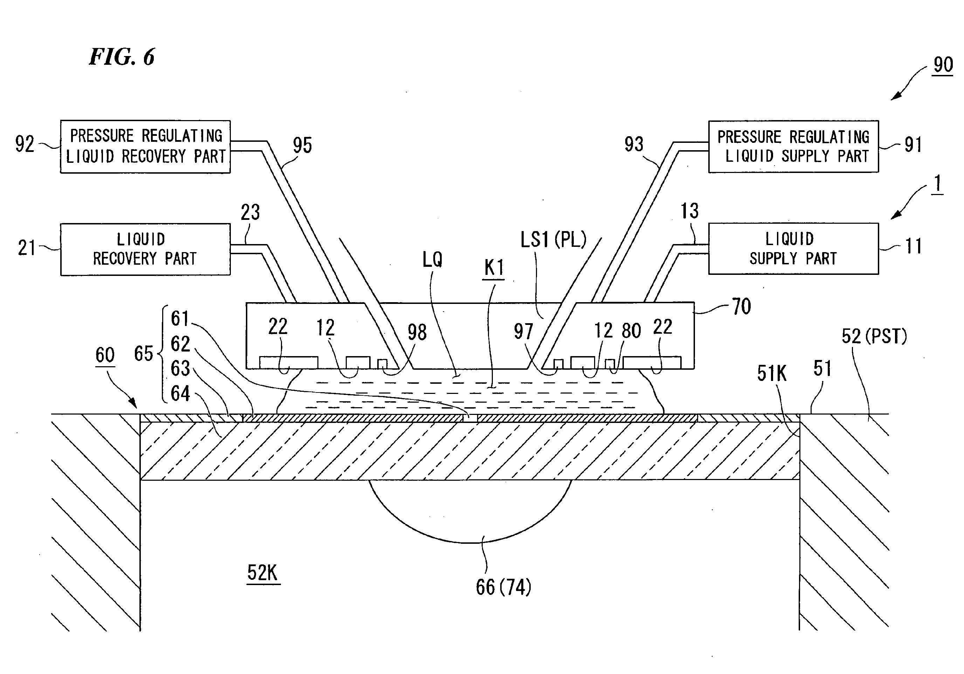

A second embodiment will be described with reference to FIG. 6. A feature of the present embodiment resides in that the exposure apparatus EX includes a pressure regulating mechanism 90 capable of regulating the pressure of the liquid LQ filled in the light path space K1. In the following description, the constituent parts identical with or equivalent to those of the foregoing embodiment will be designated by like reference numerals, and description thereof will be simplified or omitted.

Referring to FIG. 6, the exposure apparatus EX includes a pressure regulating mechanism 90 capable of regulating the pressure of the liquid LQ filled in the light path space K1. The pressure regulating mechanism 90 includes a pressure regulating liquid supply part 91 capable of adding an additional amount of liquid LQ to the liquid LQ supplied from the liquid supply mechanism 10 and a pressure regulating liquid recovery part 92 capable of recovering a partial amount of liquid LQ. The operation of the pressure regulating mechanism 90 is controlled by the control unit CONT. A supply pipe 93 is connected at a first end thereof to the pressure regulating liquid supply part 91 and at a second end thereof to a pressure regulating supply port 97 by way of a supply flow path formed within the nozzle member 70. The pressure regulating liquid supply part 91 includes a tank for receiving the liquid LQ, a compression pump and so forth. The pressure regulating supply port 97 is provided on the lower surface 70A of the nozzle member 70 and is arranged nearer to the light path space K1 than is the supply port 12 of the liquid supply mechanism 10. The liquid LQ can be supplied through the pressure regulating supply port 97 by operating the pressure regulating liquid supply part 91.

A recovery pipe 95 is connected at a first end thereof to the pressure regulating liquid recovery part 92 and at a second end thereof to a pressure regulating recovery port 98 by way of a recovery flow path formed within the nozzle member 70. The pressure regulating liquid recovery part 92 includes a vacuum system (suction device) such as a vacuum pump or the like, a gas-liquid separator for separating the liquid LQ and the gas recovered, a tank for storing the thus-recovered liquid LQ, and so forth. The pressure regulating recovery port 98 is provided on the lower surface 70A of the nozzle member 70 and is arranged nearer to the light path space K1 than is the supply port 12 of the liquid supply mechanism 10. The liquid LQ can be recovered through the pressure regulating recovery port 98 by operating the pressure regulating liquid recovery part 92.

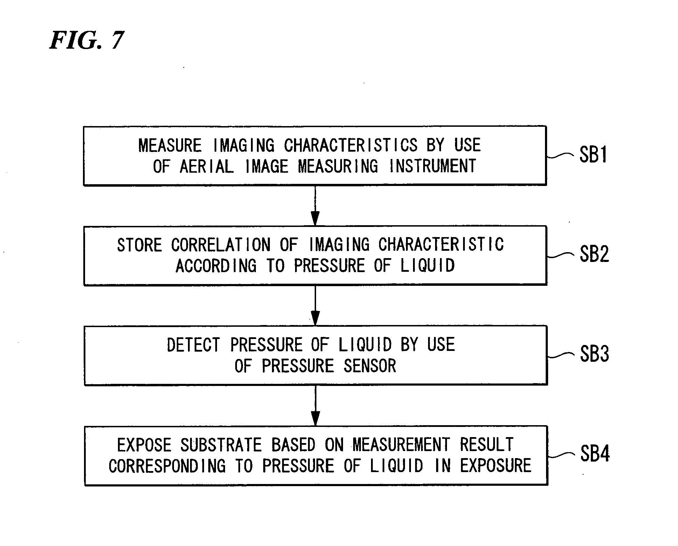

Next, a method for exposing the substrate P will be described with reference to the flowchart of FIG. 7. At the time of exposing the substrate P, the control unit CONT measures the imaging characteristics of an image formed through the projection optical system PL and the liquid LQ, which serves as one of the exposure conditions, by use of the aerial image measuring device 60 (step SB1). At this time, the control unit CONT performs the measurement with the aerial image measuring device 60 while the pressure of the liquid LQ filled between the projection optical system PL and the slit plate 65 is being changed by use of the pressure regulating mechanism 90. By dosing so, the measurement of the imaging characteristics under a plurality of pressure conditions of the liquid LQ is executed. The control unit CONT stores in the storage unit MRY, the correlation between the pressure of the liquid LQ (the detection result of the pressure sensor 80) during execution of measurement by use of the aerial image measuring device 60 and the imaging characteristics corresponding to the pressure (the measurement result of the aerial image measuring device 60) (step SB2).

Based on the correlation between the pressure of the liquid LQ forming the liquid immersion region LR, which has been found in step SB1, and the imaging characteristics associated with the projection optical system PL and the liquid LQ, the control unit CONT derives a correction value in the imaging characteristics of the projection optical system PL in accordance with each of the plurality of pressure conditions of the liquid LQ, which is required to optimize the imaging characteristics associated with the projection optical system PL and the liquid LQ. In other words, based on the correlation between the pressure of the liquid LQ forming the liquid immersion region LR and the imaging characteristics associated with the projection optical system PL and the liquid LQ, the control unit CONT derives an operation value (correction value) of the imaging characteristic adjusting unit LC in accordance with each of the plurality of pressure conditions of the liquid LQ, which is required to assure an optimized imaging state of the pattern image formed through the projection optical system PL and the liquid LQ. The control unit CONT stores in the storage unit MRY, the information on the correction value for the imaging characteristics of the projection optical system PL in accordance with each of the plurality of pressure conditions of the liquid LQ, which is required to optimize the imaging characteristics associated with the projection optical system PL and the liquid LQ.

Subsequently, the control unit CONT displaces the substrate stage PST in the XY directions and allows the liquid immersion region LR formed on the image plane side of the projection optical system PL to be moved away from the slit plate 65. As in the first embodiment described earlier, the control unit CONT performs measurement by use of the illuminance unevenness sensor 400 and/or the irradiation amount sensor 600 and, prior to exposing the substrate P, finds the positional relationship (base line value) between a detection reference position of the substrate alignment system 350 and a projection position of the pattern image.

Next, in order to expose the substrate P for the manufacture of devices, the control unit CONT displaces the substrate stage PST in the XY directions and brings the liquid immersion region LR of the liquid LQ formed on the image plane side of the projection optical system PL onto the substrate P. By doing so, the liquid LQ is held between the projection optical system PL (first optical element LS1) and the substrate P in the process of exposing the substrate P. It is a matter of course that, at the time of exposing the substrate P for the manufacture of devices, the mask M for forming the devices is held on the mask stage MST.

The control unit CONT fills the light path space K1 formed between the projection optical system PL and the substrate P with the liquid LQ and detects the pressure of the liquid LQ by use of the pressure sensor 80 (step SB3). At the time when the pressure of the liquid LQ is detected by use of the pressure sensor 80, the control unit CONT detects the pressure of the liquid LQ while the substrate P being displaced relative to the light path space K1 under the same conditions as those used in exposing the substrate P and in a state that the light path space K1 between the projection optical system PL and the substrate P is filled with the liquid LQ.

Based on the pressure of the liquid LQ filled into the light path space K1 formed between the projection optical system PL and the substrate P, i.e., the measurement result from the aerial image measuring device 60 for the liquid LQ in the process of exposure of the substrate P, the control unit CONT determines the imaging characteristics most suitable for the pressure of the liquid LQ in performing the exposure. That is to say, in step SB2, the measurement result of the imaging characteristics under each of the plurality of pressure conditions of the liquid LQ is stored in the storage unit MRY. By referring to the storage unit MRY, the control unit CONT can find optimal imaging characteristics in accordance with the pressure of the liquid LQ in exposure.

And, based on the imaging characteristics thus found, the control unit CONT adjusts the imaging characteristics of the projection optical system PL by use of the imaging characteristic adjusting unit LC. Then, in a state that the light path space K1 formed between the projection optical system PL and the substrate P is filled with the liquid LQ, the exposure light EL is emitted from the illumination optical system IL to illuminate the mask M with the exposure light EL, and the pattern image of the mask M is projected on the substrate P through the liquid LQ in the liquid immersion region LR formed between the projection optical system PL and the substrate P (step SB4).

As described above, measurement can be performed while the pressure of the liquid LQ is being changed, and the substrate P can be exposed based on the measurement result corresponding to the pressure of the liquid LQ in exposure.

Furthermore, although the pressure of the liquid LQ existing between the projection optical system PL and the substrate P is detected prior to starting exposure of the substrate P in the second embodiment set forth above, the pressure of the liquid LQ may be detected during the course of exposing the substrate P and the imaging characteristic adjusting unit LC may be controlled based on the detection result thus obtained.

Moreover, the pressure of the liquid LQ in exposure is detected by use of the pressure sensor 80 in step SB3 of the present embodiment. However, in case the pressure of the liquid LQ in exposure is already known, it may be possible to expose the substrate P, based on the measurement result from the aerial image measuring device 60 corresponding to the known pressure of the liquid LQ in exposure but without having to use the pressure sensor 80.

Furthermore, in the respective embodiments described above, the pressure of the liquid LQ is measured by use of the pressure sensor 80 provided in the nozzle member 70. However, since an electric drive power for operating, e.g., a voice coil motor in the Z-drive mechanisms 58 is changed in response to a pressure variation of the liquid immersion region LR, it may be possible to detect the pressure of the liquid LQ based on the electric drive power.

Furthermore, in the respective embodiments described above, the imaging state of the pattern image on the substrate P is adjusted by controlling the imaging characteristic adjusting unit LC for adjusting the imaging characteristics of the projection optical system PL. Alternatively, it may be possible to displace the mask M or adjust the wavelength of the exposure light EL. Moreover, in case the position of the image plane formed through the projection optical system PL and the liquid LQ is affected by the difference between the pressure of the liquid LQ in exposure and that in measurement, the Z-tilt stage 52 may be controlled by taking into account the pressure difference of the liquid LQ.

Furthermore, in the respective embodiments described above, the aerial image measuring device 60 has been described as an example of the measuring device having the measuring member on which the liquid immersion region LR is formed. Alternatively, the imaging state of the pattern image may be adjusted and the substrate P may be exposed by considering the difference between the pressure of the liquid LQ in the process of exposing the substrate P and the pressure of the liquid LQ in the process of performing measurement with a wavefront aberration measuring device as disclosed in, e.g., PCT International Publication No. WO 99/60361 (corresponding to U.S. Patent No. 6,819,414) and U.S. Patent No. 6,650,399. Moreover, in the foregoing embodiments, the imaging state of the pattern image is adjusted and the substrate P is exposed by taking into account the difference between the pressure of the liquid LQ in performing the measurement and the pressure of the liquid LQ in exposing the substrate P. Alternatively, it may be possible to ensure that there will be no difference between the pressure of the liquid LQ in performing the measurement and the pressure of the liquid LQ in exposing the substrate P.

As set forth above, the liquid LQ used in the present embodiment is pure water. The pure water provides an advantage that it can be easily acquired in large quantities in a semiconductor fabricating factory, and the like, and does not adversely affect a photoresist on the substrate P or an optical element (lens). Moreover, the pure water has no adverse effect on the environment and contains an extremely small amount of impurities, which comes up to an expectation that the pure water serves to cleanse the surface of the substrate P and the surface of the optical element provided on the tip end surface of the projection optical system PL. Furthermore, in case the pure water supplied from a factory, and the like, exhibits a low degree of purity, the exposure apparatus may be provided with an ultrapure water production device.

And, the pure water (typical water) is said to have a refractive index "n" of about 1.44 with respect to the exposure light EL whose wavelength is about 193nm. In case ArF excimer laser light (with a wavelength of 193nm) is used as the exposure light EL, the wavelength thereof is reduced to 1/n on the substrate P, i.e., 134nm, thus providing an increased resolution power. Furthermore, the depth of focus becomes "n" times, i.e., 1.44 times, as great as that in the air. Thus, the aperture number of the projection optical system PL can be further increased in case it is desirable to secure about the same depth of focus as is available in the air. This also helps to enhance the resolution power.

In the present embodiment, the optical element LS 1 is attached to the tip end of the projection optical system PL. Optical characteristics, e.g., aberrations (a spherical aberration, a coma aberration and the like), of the projection optical system PL can be adjusted by means of this lens. Furthermore, the optical element attached to the tip end of the projection optical system PL may be either an optical plate used in adjusting the optical characteristics of the projection optical system PL or a parallel flat panel that permits transmission of the exposure light EL therethrough.

Furthermore, in the event that the flow of the liquid LQ creates a high pressure between the optical element at the tip end of the projection optical system PL and the substrate P, it may be possible to fixedly secure the optical element against any movement otherwise caused by the pressure, instead of making the optical element replaceable.

Moreover, with the projection optical system of the foregoing embodiments, the light path space on the image plane side of the optical element arranged at the tip end thereof is filled with the liquid. Alternatively, it may be possible to employ a projection optical system in which the light path space on the mask side of the optical element arranged at the tip end thereof is also filled with the liquid, as disclosed in PCT International Publication No. WO 2004/019128.

Furthermore, other liquid than water may be used as the liquid LQ, although the liquid LQ is water in the present embodiment. As an example, in case a source of the exposure light EL is an F₂ laser that generates F₂ laser light with no ability to penetrate water, the liquid LQ may be, e.g., fluorine-based liquid, such as perfluorinated polyether (PFPE) and fluorinated oil, permitting penetration of the F₂ laser light. In this case, the portion making contact with the liquid LQ is subjected to a hydrophilic treatment by, e.g., forming a thin film on that portion with a material of low-polarity molecular structure including fluorine. In addition to the above, it may be possible to use, as the liquid LQ, a material (e.g., cedarwood oil) that permits transmission of the exposure light EL, has a refractive index as high as possible and exhibits stability with respect to the projection optical system PL or a photoresist coated on the surface of the substrate P.

Moreover, as the substrate P of the respective embodiments described above, it is possible to use not only a semiconductor wafer for the manufacture of semiconductor devices but also a glass substrate for display devices, a ceramics wafer for thin film magnetic heads and a original plate of mask or reticle (a synthetic quartz wafer or a silicon wafer) used in an exposure apparatus.

As for the exposure apparatus EX, the present invention may be applied to a step-and-repeat type projection exposure apparatus (a stepper) that collectively exposes the pattern of the mask M with the mask M and the substrate P being kept in a stopped state and sequentially moves the substrate P step by step, as well as a step-and-scan type scanning exposure apparatus (a scanning stepper) that scan-exposes the pattern of the mask M by synchronously moving the mask M and the substrate P.

Furthermore, as for the exposure apparatus EX, the present invention may be applied to an exposure apparatus of the type collectively exposing the reduced image of a first pattern on a substrate P by use of a projection optical system (e.g., a refraction type projection optical system with a reduction ratio of 1/8 but with no reflection element) in a state that the first pattern and the substrate P are kept nearly immovable. In this case and subsequent to the above process, the present invention may be applied to a stitching exposure apparatus by which the reduced image of a second pattern is partially overlapped with the first pattern and collectively exposed on the substrate P by use of the projection optical system in a state that the second pattern and the substrate P are kept nearly immovable. Moreover, as for the stitching exposure apparatus, the present invention may be applied to a step-and-stitch type exposure apparatus by which at least two patterns are transferred to the substrate P in a partially overlapped state and the substrate P is moved step by step.

The present invention may also be applied to a twin stage type exposure apparatus provided with a plurality of substrate stages, as disclosed in Japanese Patent Application, Publication No. H10-163099, Japanese Patent Application, Publication No. H10-214783, Published Japanese Translation No. 2000-505958 of the PCT International Publication and so forth.

Furthermore, the present invention may be applied to an exposure apparatus that includes a substrate stage for holding a substrate and a measurement stage which carries a reference member with a reference mark and various kinds of photoelectric sensors (an aerial image measuring device, a wavefront measuring device and the like), as disclosed in Japanese Patent Application, Publication Nos. H11-135400 and 2000-164504.

Although the exposure apparatus employed in the foregoing embodiments is of the type locally filling the liquid between the projection optical system PL and the substrate P, the present invention may be applied to a liquid immersion exposure apparatus for performing exposure in a state that the entire surface of an exposure target substrate is soaked in the liquid, as disclosed in Japanese Patent Application, Publication No. H06-124873, Japanese Patent Application, Publication No. H10-303114, U.S. Patent No. 5,825,043 and so forth.

As for the kind of exposure apparatus EX, the present invention is not limited to the exposure apparatus for the manufacture of semiconductor devices that exposes a semiconductor device pattern on the substrate P but may be extensively applied to an exposure apparatus for the manufacture of liquid crystal display devices or for the manufacture of displays, an exposure apparatus for the manufacture of thin film magnetic heads, image pickup devices (CCD), reticles or masks, and other exposure apparatuses.

Furthermore, in the foregoing embodiments, use is made of a light transmitting mask in which a specified light shielding pattern (or a phase pattern or a photosensitive pattern) is formed on a light transmitting substrate. Alternatively, it may be possible to use an electronic mask, as disclosed in, e.g., U.S. Patent No. 6,778,257, by which a transmission pattern, a reflection pattern or a light emitting pattern is formed based on an electronic data of the pattern to be exposed.

Furthermore, the present invention may be applied to a markless exposure apparatus (lithography system), as disclosed in PCT International Publication No. WO 2001/035168, that can expose a line-and-space pattern on a substrate P by forming an interfering stripes on the substrate P.

As described above, the exposure apparatus EX in accordance with the embodiments of the present invention is manufactured by assembling various subsystems, including the respective elements recited in the claims of the subject application, so as to maintain specified mechanical, electrical and optical accuracy. In order to assure the various kinds of accuracy, calibration is conducted before and after the assembly process to accomplish optical accuracy for various optical systems, mechanical accuracy for various mechanical systems and electrical accuracy for various electric systems. The process for assembling the various subsystems into the exposure apparatus includes the tasks of mechanically interconnecting the various subsystems, connecting wire lines of an electric circuit and connecting pipelines of a pneumatic pressure circuit. It is a matter of course that individual processes for assembling each of the subsystems precede the process for assembling the various subsystems into the exposure apparatus. Once the process for assembling the various subsystems into the exposure apparatus comes to an end, general calibration is executed to assure various kinds of accuracy for the exposure apparatus as a whole: Moreover, it is desirable that the exposure apparatus be manufactured in a clean room whose temperature and degree of cleanliness are controlled.

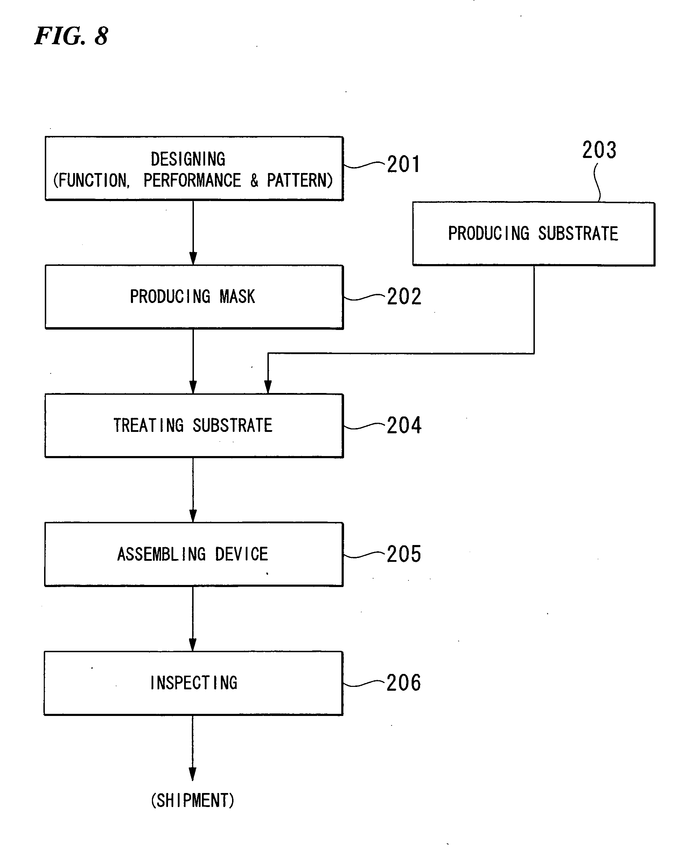

As illustrated in FIG 8, micro devices such as semiconductor devices and the like are manufactured by way of a step 201 of designing a function, a performance and a pattern of the micro devices, a step 202 of producing a mask (reticle) based on the designing step, a step 203 of producing a substrate as a base member of the devices, a step 204 including a treatment by which a mask pattern is exposed on the substrate by means of the exposure apparatus EX of the foregoing embodiments, a step 205 of assembling the devices (including a dicing step, a bonding step and a packaging step) and an inspecting step 206.

## Claims

1. An exposure method for exposing a substrate by forming a liquid immersion region on the substrate by use of a liquid immersion mechanism and irradiating the substrate with exposure light through liquid of the liquid immersion region, comprising:
forming a liquid immersion region on a measuring member by use of the liquid immersion mechanism and performing measurement by receiving measurement light through liquid of the liquid immersion region, in order to determine an exposure condition of the substrate; and
exposing the substrate by taking into account a difference between a pressure of the liquid in the process of measurement and that in the process of exposure and a result of the measurement thus performed.

2. The exposure method according to claim 1, wherein the pressure difference of the liquid is caused by a difference in contact angles that a surface of the measuring member and a surface of the substrate make with the liquid, and
wherein the substrate is exposed in accordance with the contact angles that the surface of the measuring member and the surface of the substrate make with the liquid.

3. The exposure method according to claim 1 or 2, wherein the pressure difference of the liquid is caused by a difference between a moving speed of the measuring member in the process of measurement and a moving speed of the substrate in the process of exposure, and
wherein the substrate is exposed in accordance with the moving speed of the measuring member in the process of measurement and the moving speed of the substrate in the process of exposure.

4. The exposure method according to any one of claims 1 to 3, wherein an imaging state of a pattern image projected on the substrate is adjusted in consideration of the pressure difference of the liquid and the measurement result, and the substrate is exposed with the adjusted pattern image.

5. The exposure method according to claim 4, wherein the exposure light is irradiated on the substrate through a projection optical system, and the imaging state of the pattern image is adjusted by adjusting the projection optical system.

6. The exposure method according to any one of claims 1 to 3, wherein the exposure condition required to expose the substrate is determined based on the measurement result, and
wherein the exposure condition is corrected based on the pressure difference, and the substrate is exposed under the exposure condition thus corrected.

7. The exposure method according to claim 6, wherein a correlation between a correction value of the exposure condition and the pressure difference is determined in advance.

8. The exposure method according to claim 6 to 7, wherein the exposure condition comprises imaging characteristics of the projection optical system that projects the pattern image on the substrate.

9. The exposure method according to any one of claims 1 to 5, wherein the measurement is performed while changing the pressure of the liquid, and
wherein the substrate is exposed based on the measurement result corresponding to the pressure of the liquid in the process of exposure.

10. The exposure method according to any one of claims 1 to 9, wherein the liquid is held between an optical member through which the exposure light passes and the substrate in the process of exposure,
wherein the liquid is held between the optical member and the measuring member in the process of measurement, and
wherein the optical member is displaced by the pressure of the liquid.

11. The exposure method according to any one of claims 1 to 10, wherein the pressures of the liquid in the process of measurement and in the process of exposure are respectively detected to obtain information on the pressure difference of the liquid.

12. A device fabricating method comprising: using the exposure method according to any one of claims 1 to 11.

13. An exposure apparatus for exposing a substrate by forming a liquid immersion region on the substrate and irradiating the substrate with exposure light through liquid in the liquid immersion region, comprising:
a liquid immersion mechanism that forms a liquid immersion region on an object;
a measuring device that performs measurement to determine an exposure condition of the substrate, the measuring device having a measuring member, the measuring device adapted to receive measurement light through liquid in the liquid immersion region formed on the measuring member by use of the liquid immersion mechanism; and
an exposure control unit that forms the liquid immersion region on the substrate by use of the liquid immersion mechanism and exposes the substrate in consideration of a measurement result obtained by the measuring device and a difference between a pressure of the liquid in the process of measurement and that in the process of exposure.

14. The exposure apparatus according to claim 13, wherein the exposure control unit corrects the exposure condition determined by the measurement result of the measuring device based on the pressure difference and exposes the substrate under the exposure condition thus corrected.

15. The exposure apparatus according to claim 14, further comprising a storage unit that stores a correlation between a correction value of the exposure condition and the pressure difference.

16. The exposure apparatus according to any one of claims 13 to 15, further comprising a projection optical system through which the exposure light passes and an adjusting unit that adjusts imaging characteristics of the projection optical system, and
wherein the exposure control unit controls the adjusting unit, based on the measurement result obtained by the measuring device and the difference between the pressure of the liquid in the process of measurement and that in the process of exposure.

17. The exposure apparatus according to any one of claims 13 to 16, further comprising a pressure sensor that detects the pressures of the liquid in the process of measurement and in the process of exposure to find the pressure difference of the liquid.

18. The exposure apparatus according to any one of claims 13 to 17, further comprising a pressure regulating mechanism that regulates the pressure of the liquid, and
wherein the measuring device performs the measurement while the pressure of the liquid is being changed by use of the pressure regulating mechanism.

19. A device fabricating method comprising: using the exposure apparatus according to any one of claims 13 to 18.
